# EUROPÄISCHE PATENTSCHRIFT

(11) **EP 0 972 295 B1**
(45) Veröffentlichungstag und Bekanntmachung des Hinweises auf die Patenterteilung: **22.01.2003**
(21) Anmeldenummer: 98909455.2
(22) Anmeldetag: 12.02.1998
(51) Int. Cl.: H01H 85/00

(54) **BAUGRUPPE ZUM SCHALTEN ELEKTRISCHER LEISTUNGEN**
UNIT FOR SWITCHING ELECTRICAL ENERGY
ENSEMBLE POUR LA COMMUTATION D'INSTALLATIONS D'ENERGIE

(30) Priorität: 04.04.1997 DE 19713984
(43) Veröffentlichungstag der Anmeldung: 19.01.2000
(73) Patentinhaber: Continental ISAD Electronic Systems GmbH & Co. oHG, 86899 Landsberg/Lech (DE)
(72) Erfinder: GRÜNDL, Andreas, D-81377 München (DE); HOFFMANN, Bernhard, D-82319 Starnberg (DE)
(74) Vertreter: Schmidt, Steffen J., Dipl.-Ing.
(86) Internationale Anmeldenummer: EP9800796
(87) Internationale Veröffentlichungsnummer: WO98045867

(56) Entgegenhaltungen:
- EP-A- 0 429 188
- EP-A- 0 586 793
- WO-A-95/13860
- DE-A- 3 740 236
- FR-A- 2 580 762

## Beschreibung

Die vorliegende Erfindung betrifft eine Baugruppe zum Schalten elektrischer Leistungen, bei der wenigstens ein Halbleiterschalter in einer Leistungselektronikbaugruppe angeordnet ist.

Derartige Leistungselektronikbaugruppen sind z.B. in Form von Halbbrückenanordnungen zur Bildung von Wechselrichtern für die unterschiedlichsten Anwendungsbereiche, z.B. zur Speisung von Drehfeldmaschinen, Permanentmagnetmotoren und dergl. im Einsatz (siehe z.B. DE-A-40 27 969).

Allerdings besteht hier das Problem, daß die Leistungsdichte, d.h. die abgegebene Leistung bezogen auf das Volumen der Anordnung bei den herkömmlichen Anordnungen relativ gering ist. Außerdem ist das Gewicht der herkömmlichen Anordnungen relativ hoch.

Aus der EP 586 793 B1 ist eine Halbbrückenanordnung bekannt, die demgegenüber eine erheblich verbesserte Leistungsdichte hat. Dabei ist der eingangs beschriebene Halbleiterschalter in einer Halbbrückenanordnung angeordnet, die dahingehend weitergebildet ist, daß die Kondensatoranordnung durch wenigstens einen Flächenkondensator an einer mehrere derartiger Halbleiterschalter tragenden Platine und/oder durch wenigstens einen als Hohlwickel geformten Wickelkondensator gebildet ist, wobei die Halbleiterschalter in dem als Hohlwickel gebildeten Wickelkondensator angeordnet sind und eine Fluidkühlung in dem Hohlwickel vorgesehen ist. Auf den Inhalt dieser Druckschrift wird hiermit ausdrücklich Bezug genommen.

Ausgehend hiervon betrifft die Erfindung eine Weiterentwicklung dieser bekannten Anordnung, die dazu dient, die Leistungsdichte weiter zu steigern, die Anwendungsbereiche dieser Anordnung zu vergrößern und die Herstellung und den Betrieb dieser Anordnung kostengünstiger, einfach und sicherer zu machen.

Gemäß der Erfindung ist der Halbleiterschalter in einem druckfesten Behälter angeordnet, der teilweise mit einer Inertflüssigkeit gefüllt ist, um im Betrieb eine Fluidkühlung des Halbleiterschalters zu bewirken, ist das Innere des Behälters mit einem Kühlkreislauf gekoppelt, wobei wenigstens eine Dampfleitung von dem Behälter zu einem Kühler führt, und wenigstens eine Flüssigkeitsleitung von dem Kühler zu dem Behälter führt, wobei die Flüssigkeitsleitung zumindest abschnittsweise im Innern der Dampfleitung angeordnet ist und von einer Anschlußstelle an den Behälter in das Innere des Behälters so weit verlängert ist, daß ihr freies Ende unterhalb des Füssigkeitsspiegels der Kühlflüssigkeit mündet.

Damit ist der druckfeste Behälter für die Verbindungen mit dem Kühlkreislauf nur einmal mit einem Durchbruch oder einer Öffnung zu versehen. Außerdem ist der Platzbedarf für die Leitungen zu/von dem Kühler verringert.

Bevorzugt ist die Anordnung derart weitergebildet, daß die Dampfleitung kühlerseitig an einem Verteilerraum mündet, und die Flüssigkeitsleitung kühlerseitig an einem Sammelraum mündet, wobei zwischen dem Verteilerraum und dem Kühlerraum wenigstens eine Kühlleitung angeordnet ist, an deren Innenwand Dampf aus der Dampfleitung kondensiert und als Flüssigkeit in den Sammelraum fließt.

Die Kühlleitungen können auch zwangsgekühlt sein. Dazu kann beim Einsatz der erfindungsgemäßen Anordnung in einem Kraftfahrzeug der Fahrtwind und/oder ein Gebläse dienen. Alternativ dazu kann auch eine Flüssigkeitskühlung als Wärmesenke für die Kühlleitungen dienen.

In einer bevorzugten Ausführungsform der Erfindung ist an dem Verteilerraum über eine Drosselstelle ein Ausgleichsbehälter angeschlossen.

Weitere Eigenschaften, Merkmale und alternative Ausgestaltungen der Erfindung werden nachstehend unter Bezugnahme auf die Zeichnung erläutert, in der eine derzeit bevorzugte Ausführungsform des Erfindungsgegenstandes veranschaulicht ist.

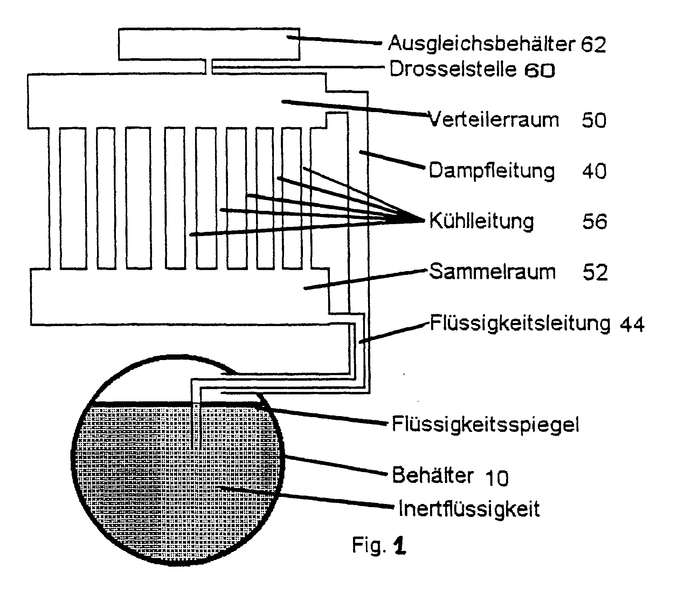

Fig. 1 zeigt eine schematische Querschnittsdarstellung eines Aspektes der Erfindung.

Die erfindungswesentlichen Aspekte sind beispielhaft in einer Halbbrückenanordnung verwirklicht, wobei als ein mögliches Anwendungsbeispiel für eine solche Halbbrückenanordnung ein einphasiger Wechselrichter dienen kann, der mit zwei identischen Halbbrückenanordnungen aufgebaut ist. Lediglich zur Erläuterung wird daher nachstehend der prinzipielle Aufbau einer solchen Anordnung erläutert.

Die Halbbrückenanordnung weist parallel geschaltete Paare MOSFETs auf, die als Halbleiterschalter wirken. Jeweils zwei der MOSFETs sind in Serie geschaltet, so daß jeweils der erste MOSFET jedes Paares mit seinem Source-Anschluß auf einem hohen Spannungspotential V_{SS} liegt, und jeder zweite MOSFET jedes Paares mit seinem Drain-Anschluß auf einem niedrigen Spannungspotential V_{DD} liegt. Dabei ist zur Bildung eines Ausgangsanschlusses der Drain-Anschluß jedes der ersten MOSFETs mit dem Source-Anschluß jedes der zweiten MOSFETs verbunden. Jeweils eine Ansteuereinrichtung für die Gruppe der ersten MOSFETs bzw. der Gruppe der zweiten MOSFETs ist mit den parallel geschalteten Steuereingängen jeder Gruppe der ersten und zweiten N-Kanal MOSFETs verbunden.

Zwischen dem hohen und dem niedrigen Spannungspotential V_{SS} und V_{DD} ist ein Kondensator angeordnet, der als Stützkondensator wirkt. Die Kondensatoranordnung ist zum einen durch einen Flächenkondensator an einer die MOSFETs tragenden Platine gebildet. Zum anderen ist die Kondensatoranordnung durch einen als Hohlwickel geformten Wickelkondensator gebildet. Der Hohlwickel ist im wesentlichen zylinderförmig gestaltet und besteht aus mehreren Lagen von Kupferschichten und jeweils einer Isolierschicht. Im Innern des als Hohlwickel ausgebildeten Wickelkondensators sind mehrere Platinen mit einzelnen Halbleiteranordnungen übereinandergeschichtet. Der Hohlwickel ist an einem Ende fluiddicht mit einer konvexen Abdeckkappe verschlossen, während er sich am anderen Ende flaschenförmig verjüngt, um in einem Ansatzstutzen auszulaufen, an dem die Anschlüsse für die Versorgungsspannungen, die Ausgangsleitungen, und die Steuerleitungen nach außen treten.

Der Hohlwickel bildet einen Behälter 10, der bis etwa 15 bar druckfest ausgebildet ist. Das Innere des Hohlwickels ist mit einem flüssigen Fluorkohlenwasserstoff gefüllt, wobei die Flüssigkeit die Halbleiterschalter 12 bedeckt. Dabei ist ein freier Raum zwischen dem Flüssigkeitsspiegel 14 (siehe z.B. Fig. 3) und der Innenwand des Behälters 10, so daß eine gasförmige Phase des Fluorkohlenwasserstoffs aus der flüssigen Phase austreten kann. Der Gasdruck in dem Hohlwickel ist entsprechend der Gasdruckkurve des Fluorkohlenwasserstoffs zwischen 50 mbar und 3 bar so eingestellt, daß bereits bei geringfügiger Erwärmung der MOSFETs im Betrieb die flüssige Phase der Fluorkohlenwasserstoffs zu sieden beginnt. So ist erreichbar, daß die Temperaturdifferenz zwischen den Halbleiterschaltern und der den Hohlwickel umgebenden Atmosphäre lediglich etwa 10°C beträgt.

Die Gasphase der Inertflüssigkeit wird von außen durch eine an den Behälter angeschlossene Konvektionskühlung oder durch Gebläsekühlung gekühlt (siehe z.B. Fig. 1). Dabei kondensiert die Gasphase des Fluorkohlenwasserstoffs an der von außen gekühlten Innenwand der Kühlleitungen und wird in flüssiger Form über eine Flüssigkeitsleitung wieder dem flüssigen Fluorkohlenwasserstoff im Innern des Behälters zugeführt, der die MOSFETs umgibt.

In Fig. 1 ist der mit Inertflüssigkeit gefüllte Behälter 10 gezeigt, dessen Inneres mit einem Kühlkreislauf gekoppelt ist. Dabei führt eine Dampfleitung 40 von dem Behälter 10 zu einem Kühler 42, und eine Flüssigkeitsleitung 44 von dem Kühler 42 zu dem Behälter 10. Die Flüssigkeitsleitung 44 ist abschnittsweise im Innern der Dampfleitung 40 angeordnet und von einer Anschlußstelle 46 an den Behälter 10 in das Innere des Behälters 10 so weit verlängert, daß ihr freies Ende unterhalb des Füssigkeitsspiegels der Inertflüssigkeit mündet. Die Dampfleitung 40 mündet kühlerseitig an einem Verteilerraum 50 und die Flüssigkeitsleitung mündet kühlerseitig an einem Sammelraum. Alternativ dazu kann die Dampfleitung 40 auch am Sammelraum 52 münden. In diesem Fall steigt der Dampf in den Kühlleitungen 50 nach oben und die Flüssigkeit in den Kühlleitungen 50 nach unten. Zwischen dem Verteilerraum 50 und dem Sammelraum 52 sind mehrere parallel verlaufenden Kühlleitungen 56 angeordnet, an deren Innenwand Dampf aus der Dampfleitung 40 kondensiert und als Flüssigkeit in den Sammelraum 52 und von dort in den Behälter 10 fließt.

An dem Verteilerraum 50 ist über eine Drosselstelle 60 ein Ausgleichsbehälter 62 angeschlossen.

## Patentansprüche

1. Baugruppe zum Schalten elektrischer Leistungen, bei der
- ein Halbleiterschalter in einem druckfesten Behälter angeordnet ist, der teilweise mit einer Inertflüssigkeit gefüllt ist, um im Betrieb eine Fluidkühlung des Halbleiterschalters zu bewirken;
**dadurch gekennzeichnet, daß**
- das Innere des Behälters mit einem Kühlkreislauf gekoppelt ist, wobei
- wenigstens eine Dampfleitung von dem Behälter zu einem Kühler führt, und
- wenigstens eine Flüssigkeitsleitung von dem Kühler zu dem Behälter führt, wobei
- die Flüssigkeitsleitung zumindest abschnittsweise im Innern der Dampfleitung angeordnet ist und von einer Anschlußstelle an den Behälter in das Innere des Behälters so weit verlängert ist, daß ihr freies Ende unterhalb des Füssigkeitsspiegels der Kühlflüssigkeit mündet.

2. Baugruppe nach Anspruch 1, **dadurch gekennzeichnet, daß**
- die Dampfleitung kühlerseitig an einem Verteilerraum mündet,
- die Flüssigkeitsleitung kühlerseitig an einem Sammelraum mündet, wobei
- zwischen dem Verteilerraum und dem Kühlerraum wenigstens eine Kühlleitung angeordnet ist, an deren Innenwand Dampf aus der Dampfleitung kondensiert und als Flüssigkeit in den Sammelraum fließt.

3. Baugruppe nach Anspruch 1, **dadurch gekennzeichnet, daß**
- an dem Verteilerraum über eine Drosselstelle ein Ausgleichsbehälter angeschlossen ist.

## Claims

1. An assembly for switching electrical power, wherein
- a semiconductor switch is arranged in a pressure-resistant vessel which is partially filled with an inert liquid in order to effect a fluid cooling of the semiconductor switch during operation;
**characterised in that**
- the interior of the vessel is coupled with a cooling circuit, with
- at least one vapour line leading from the vessel to a radiator,
- at least one liquid line leading from the radiator to the vessel, with
- the liquid line being arranged at least sectionwise within the vapour line and being extended from a connection point at the vessel into the interior of the vessel to such a length that its free end opens below the liquid level of the cooling liquid.

2. The assembly according to Claim 1, **characterised in that**
- the vapour line at the radiator side opens into a manifold chamber,
- the liquid line at the radiator side opens into a collecting chamber, with
- at least one cooling line being arranged between the manifold chamber and the radiator chamber, at the inner wall of which vapour from vapour line condensates and in the form of a liquid flows into the collecting chamber.

3. The assembly according to Claim 1, **characterised in that**
- a compensating tank is connected with the manifold chamber via a throttle section.

## Revendications

1. Groupe constitutif pour la commutation de puissances électriques, dans lequel
- on dispose un commutateur à semi-conducteur dans un récipient résistant à la pression qui est rempli en partie avec un liquide inerte, pour provoquer un refroidissement par fluide du commutateur à semi-conducteur en service;
**caractérisé en ce que**
- l'intérieur du récipient est couplé avec un circuit de refroidissement,
- au moins un conduit de vapeur mène du récipient à un dispositif de refroidissement, et
- au moins un conduit de liquide mène du dispositif de refroidissement au récipient,
- le conduit de liquide étant disposé au moins par sections à l'intérieur du conduit de vapeur et se prolongeant à partir d'un emplacement de raccordement au récipient à l'intérieur du récipient suffisamment pour que son extrémité libre aboutisse au-dessous du niveau du liquide de refroidissement.

2. Groupe constitutif selon la revendication 1, **caractérisé en ce que**
- le conduit de vapeur débouche du côté du dispositif de refroidissement dans un volume de distribution,
- le conduit de liquide débouche du côté du dispositif de refroidissement dans un volume de collecte,
- au moins un conduit de refroidissement étant disposé entre le volume de distribution et le volume de refroidissement, sur la paroi intérieure duquel de la vapeur provenant du conduit de vapeur se condense et s'écoule sous forme de liquide dans le volume de collecte.

3. Groupe constitutif selon la revendication 1, **caractérisé en ce que**
- un récipient d'expansion est raccordé au volume de distribution par l'intermédiaire d'un étranglement.
